# EUROPÄISCHE PATENTSCHRIFT

(11) **EP 3 058 835 B1**
(45) Veröffentlichungstag und Bekanntmachung des Hinweises auf die Patenterteilung: **01.04.2020**
(21) Anmeldenummer: 15156067.9
(22) Anmeldetag: 23.02.2015
(51) Int. Cl.: G06F 17/00, A41H 3/00, A41H 3/08, A41H 42/00, B26D 5/00

(54) **VORRICHTUNG UND VERFAHREN ZUM HERSTELLEN EINES BEKLEIDUNGSSTÜCKS**
DEVICE AND METHOD FOR PRODUCING AN ARTICLE OF CLOTHING
DISPOSITIF ET PROCÉDÉ DE FABRICATION D'UN VÊTEMENT

(43) Veröffentlichungstag der Anmeldung: 24.08.2016
(73) Patentinhaber: Schiestl, Angelo, 6336 Langkampfen (AT)
(72) Erfinder: Schiestl, Angelo, 6336 Langkampfen (AT); Choi, Justin, Philadelphia, PA 19134 (US)
(74) Vertreter: Wunderlich & Heim Patentanwälte Partnerschaftsgesellschaft mbB

(56) Entgegenhaltungen:
- WO-A1-00/70976
- WO-A1-03/099052
- DE-A1- 3 544 251
- IE-A1- 950 483
- US-A- 4 408 291
- US-A- 5 230 764
- US-A1- 2014 277 663

## Beschreibung

Die Erfindung betrifft eine Vorrichtung zum Herstellen eines Bekleidungsstücks, welches aus mehreren Teilstücken gebildet ist nach dem Oberbegriff des Anspruchs 1.

Weiterhin betrifft die Erfindung ein Verfahren zum Herstellen eines Bekleidungsstücks, welches aus mehreren Teilstücken gebildet ist nach dem Oberbegriff des Anspruchs 8.

Eine gattungsgemäße Vorrichtung und ein entsprechendes Verfahren zum Herstellen eines Bekleidungsstücks aus einer Textilbahn, welches aus mehreren Teilstücken gebildet ist, ist zum Beispiel aus der DE 102 23 375 A1 bekannt. Bei dieser Vorrichtung und dem entsprechenden Verfahren ist ein Stoffvorrat vorgesehen, welcher durch einen Drucker bedruckt und durch eine Schneidevorrichtung zu Stoffteilen konfektioniert wird, wobei die Stoffteile anschließend zu einem Bekleidungsstück zusammengenäht werden.

Die US 5,230,764 offenbart ein Verfahren zum Herstellen von Bekleidungsstücken, wobei Teilstücke eines Bekleidungsstücks entweder für eine Weiterverarbeitung aus dem Herstellungsprozess entfernt oder alternativ mit einem Futter versehen werden, welches mit den Teilstücken des Bekleidungsstücks verbunden wird. Hierbei werden die der weiteren Verarbeitung zugeführten Teilstücke sowie die mit einem Futter versehenen Teilstücke mit einer Markierung versehen und einer Nähstation zugeführt.

Die US 2014/0277663 betrifft eine Vorrichtung zum Herstellen von Bekleidungsstücken mit einer Beschneidungseinrichtung, einer Näheinrichtung und einer Finishing-Einrichtung.

Die US 5,230,764 betrifft eine Vorrichtung zur Textilverarbeitung, bei welcher eine Textilbahn zu Textilteilen eines Bekleidungsstücks geschnitten werden. Für eine Weiterverarbeitung der Teilstücke werden diese von einem Förderband entfernt und einer Nähstation zugeführt.

Insbesondere im Hinblick auf die wirtschaftliche Ausnutzung einer Textilbahn bei der Fertigung mehrerer Bekleidungsstücke in Serie oder von mehreren Einzelaufträgen kann es notwendig sein, dass einzelne Teilstücke eines Bekleidungsstücks auf der Textilbahn nicht in unmittelbarer Nachbarschaft zueinander vorgesehen sind. Dies hat zur Folge, dass Teilstücke, welche zu ein- und demselben Bekleidungsstück gehören, auf der Textilbahn zueinander in nicht-eindeutiger Weise angeordnet sind, was eine Zuordnung der Teilstücke zu einem Bekleidungsstück mit erheblichem Aufwand verbindet.

Der Erfindung liegt die **Aufgabe** zugrunde, eine Vorrichtung zum Herstellen eines Bekleidungsstücks, welches aus mehreren Teilstücken gebildet ist, sowie ein entsprechendes Herstellungsverfahren anzugeben, welche es erlauben, einzelne auszuschneidende Teilstücke eines Bekleidungsstücks auf einer Textilbahn auch in größerer räumlicher Distanz zueinander anzuordnen und dennoch eine effiziente und sichere Zuordnung der einzelnen Teilstücke zu einem gemeinsamen Bekleidungsstück zu ermöglichen.

Die Aufgabe wird nach der Erfindung einerseits durch eine Vorrichtung mit den Merkmalen des Anspruchs 1 und andererseits durch ein Verfahren mit den Merkmalen nach Anspruch 8 gelöst. Vorteilhafte Ausgestaltungen sind in den abhängigen Ansprüchen, der Beschreibung und den Figuren angegeben.

Die erfindungsgemäße Vorrichtung zum Herstellen eines Bekleidungsstücks das aus mehreren Teilstücken gebildet ist, ist durch den Kennzeichnenden Teil des Anspruchs 1 gekennzeichnet.

Weiterhin ist das erfindungsgemäß Verfahren zum Herstellen eines Bekleidungsstückes, welches aus mehreren Teilstücken gebildet ist, durch den Anspruch 8 gekennzeichnet.

Ein Grundgedanke der Erfindung besteht darin, einzelne Teilstücke eines Bekleidungsstücks, welche aus einer Textilbahn ausgeschnitten werden, zu identifizieren und so zusammenzufassen, dass das anschließende Verbinden der Teilstücke zu dem Bekleidungsstück vereinfacht ist. Das Zusammenfassen kann in einer Weise erfolgen, dass die einzelnen Teilstücke teilweise oder vollständig zueinander räumlich so angeordnet werden, wie es für das fertige Bekleidungsstück vorgesehen ist. Wahlweise können die einzelnen Teilstücke des Bekleidungsstücks durch die Sortiervorrichtung so zusammengefasst werden, wie es für das anschließende Verbinden der Teilstücke zu dem Bekleidungsstück in der Nähstation vorteilhaft ist. Besonders vorteilhaft kann es hierbei sein, dass die Teilstücke in unmittelbarer Nähe zueinander angeordnet werden. Das anschließende Verbinden der zusammengefassten Teilstücke in einer Nähstation kann durch eine Vorrichtung oder durch Arbeitskräfte geschehen. Hierbei kann in der Nähstation nicht nur ein Vernähen, sondern zusätzlich oder alternativ ein Verschweißen oder sonstiges Verbinden der Teilstücke zu dem Bekleidungsstück erfolgen.

Sowohl im Fall eines manuellen als auch eines maschinellen Verbindens kann das Zusammenfassen der Teilstücke eines Bekleidungsstücks in oben beschriebener Weise zu einer Vereinfachung des Herstellungsprozesses, einem erheblichen Zeitgewinn und somit zu einer wirtschaftlicheren Fertigung des Bekleidungsstücks während des Verbindevorgangs in der Nähstation führen. Die Erkennungseinrichtung zum Erkennen der Teilstücke eines Bekleidungsstücks kann vorzugsweise mit einer optischen Sensoreinrichtung so ausgestaltet sein, dass sie das jeweilige Teilstück anhand spezifischer Merkmale, wie Zuschnitt, Lage des Teilstücks auf der Textilbahn, Aufdruck oder mindestens einer Markierung erkennt.

Vorzugsweise weist die Erkennungseinrichtung zum Erkennen des jeweiligen Teilstücks geeignete Mittel, insbesondere Sensoren, besonders bevorzugt mindestens eine Kamera und/oder einen Laserscanner auf. Die Sortiereinrichtung weist nach der Erfindung ansteuerbare Stellglieder, wie Weichen, Klappen, Greifer oder Luftdüsen auf, durch welche eine Lage oder Bewegungsrichtung der Textilteils in gewünschter Weise veränderbar ist. Zum Transport kann in der Vorrichtung ein Endlosförderer, insbesondere ein Förderband, vorgesehen sein.

Nach einer Weiterbildung der Erfindung ist es bevorzugt, dass die Druckeinrichtung mindestens einen digitalen Druckkopf umfasst, wobei die mindestens eine Textilbahn durch den mindestens einen digitalen Druckkopf mit digitaler Druckerfarbe bedruckbar ist. Die digitale Drucktechnik hat sich im Textildruck besonders bewährt. Die Druckeinrichtung umfasst insbesondere eine Vielzahl von Spritzdüsen, mit welchen die gewünschten Farben und Motive effizient aufbringbar sind. Vor dem Drucken kann eine Vorbehandlung des Textils erfolgen. Insbesondere kann eine Vorbehandlungsflüssigkeit aufgebracht werden, welche ein Verlaufen der Druckfarbe verhindert.

Weiterhin ist es bevorzugt, dass eine Markierungseinrichtung vorgesehen ist, durch welche jedes Teilstück eines Bekleidungsstücks mit einer Markierung versehbar ist, und dass die Markierung ausgebildet ist, eine Zugehörigkeit der Teilstücke zu einem Bekleidungsstück anzugeben. Die Markierungseinrichtung kann als Teil der Druckeinrichtung ausgebildet sein, wobei die Markierung in Form eines Drucks auf dem jeweiligen Teilstück aufbringbar ist. Die Markierung des jeweiligen Teilstücks kann auch dann aufgebracht werden, wenn das Textilteil ansonsten unbedruckt bleibt. Es ist auch jede andere Form der Markierung des einzelnen Teilstücks denkbar, welche nach geläufigen Methoden eine maschinelle Erkennung ermöglicht. Dies können aufbringbare Labels sein, welche insbesondere optisch, magnetisch, induktiv oder elektronisch auslesbare Markierungen aufweisen. Vorteilhafterweise kann die Markierung auch dadurch gekennzeichnet sein, dass diese farblos oder in der Farbe der Grundfarbe der Textilbahn oder des Motivs auf das Teilstück aufgetragen wird, wobei die Information magnetisch, induktiv oder elektronisch auslesbar ist. Prinzipiell kann auch das Druckbild des jeweiligen Teilstücks, soweit vorhanden, als Markierung fungieren. Eine gedruckte Markierung kann vorzugsweise ein Barcode oder ein QR-Code sein.

Die Markierung kann so ausgebildet sein, dass sie alle wesentlichen Informationen über die Zugehörigkeit des markierten Teilstücks zu einem Bekleidungsstück und/oder zu einem Auftrag beispielsweise in kodierter Form enthält. Alternativ kann die Markierung auch so geartet sein, dass sie einen Verweis auf die Informationen für eine Zugehörigkeit des Teilstücks zu einem Bekleidungsstück und/oder zu einem Auftrag enthält. Die eigentlichen Informationen zu Bekleidungsstück und/oder dem jeweiligen Auftrag können hierbei als Eintrag in einer Datenbank der programmierbaren Steuereinheit enthalten sein. Die programmierbare Steuereinheit kann die Markierungen mittels geeigneter Einrichtungen, beispielsweise Sensoren auslesen und die erfindungsgemäße Vorrichtung entsprechend auftragsgemäß steuern. Als Auftrag sind die durch einen Benutzer zur Verfügung gestellten und relevanten Daten zu Anzahl der zu fertigenden Bekleidungsstücke, deren Größe, Grundierungsfarbe, Druck und ähnliches zu verstehen, welche benötigt werden, um die auftragsgemäße Bekleidung herzustellen.

Besonders zweckmäßig ist es nach einer Weiterbildung der Erfindung, dass die Markierung bereits vor dem Zuschnitt der Teilstücke auf der Textilbahn vorsehbar ist. Demnach kann nicht nur das zugeschnittene Teilstück selbst, sondern bereits die Textilbahn mit entsprechenden Markierungen versehen werden, welche eine Zugehörigkeit des zu erstellenden Teilstücks zu einem Bekleidungsstück und/oder einem Auftrag angibt. Die Markierung wird nach dem Vorsehen einer Grundierungsfarbe aufgebracht.

Ansonsten kann die Markierung auch vor, während oder nach dem Bedrucken des Teilstücks mit dem entsprechenden Druckbild angebracht werden.

Vorzugsweise ist die Markierung in einem Nahtbereich angeordnet, welcher am fertigen Bekleidungsstück nicht mehr sichtbar ist. Besonders vorteilhaft ist es nach einer Weiterbildung der Erfindung, dass die Teilstücke mindestens einen Textilbereich aufweisen, welcher die Markierung umfasst, wobei der Textilbereich außerhalb des Schnittmusters des Bekleidungsstücks liegt. Der Textilbereich, welcher die Markierung umfasst, kann als Erweiterung des eigentlichen Teilstücks verstanden werden, also als eine Art waschzettelartige Erweiterung verstanden werden welcher mit diesem durch die Zuschneideeinrichtung einstückig aus der Textilbahn herausgeschnitten wird. Vorzugsweise weist der Textilbereich, welcher die Markierung umfasst, eine Perforation auf, welche das Ablösen des Textilbereichs von dem Teilstück nach Vollendung des Bekleidungsstücks in einfacher Weise ermöglicht.

Eine bevorzugte Weiterbildung der Erfindung kann darin gesehen werden, dass die programmierbare Steuereinheit ausgebildet ist, von einem Kunden gesendete Bilddaten zu empfangen und auf der Textilbahn in einem vorgesehenen Druckbereich ein entsprechendes Druckbild für ein Teilstück eines Bekleidungsstücks mittels der Druckeinrichtung aufzubringen. Der Kunde kann die Bild- und Auftragsdaten gemeinsam mit anderen Daten eines Auftrags zum Herstellen eines Bekleidungsstücks wahlweise direkt vor Ort an die Vorrichtung über eine Eingabeeinrichtung mit Eingabemitteln, beispielsweise ein Benutzerterminal, oder über ein Datenfernkommunikationsmittel, beispielsweise durch einen Computer mit entsprechender Software über das Internet, übermitteln. Die programmierbare Steuereinheit kann basierend auf den vom Benutzer gesendeten Bild- und Auftragsdaten einen Druckbereich für das jeweilige Teilstück auf der mindestens einen Textilbahn auswählen und die Druckeinrichtung zum Bedrucken der Textilbahn mit einem entsprechenden Druckbild ansteuern. Hierbei kann die programmierbare Steuereinheit die relative Orientierung einzelner Druckbereiche verschiedener Teilstücke zueinander auf der Textilbahn nach Verbrauchsmaterial schonenden Gesichtspunkten anpassen.

Die Erfindung kann darin gesehen werden, dass die Textilbahn mit einer Grundfarbe vorgesehen ist und dass die Druckeinrichtung ausgebildet ist, flächig eine neue Grundfarbe aufzubringen. Um die Verwendbarkeit einer Textilbahn für möglichst viele unterschiedliche Druckaufträge zu gewährleisten, kann es vorteilhaft sein, die Textilbahn mit einer einheitlichen Farbe, vorzugsweise als möglichst farbarme, insbesondere weiße Textilbahn, vorzusehen. Besonders bevorzugt weist die Textilbahn eine Farbe auf, welche eine möglichst deckende Grundierung mit einer Grundierfarbe ermöglicht. Sollte auftragsgemäß eine andere Grundfarbe des Textils gewünscht sein, kann diese beispielsweise mittels der Druckeinrichtung geändert und flächig aufgetragen werden. Die Druckeinrichtung ist zu diesem Zweck dahingehend ausgestaltet, dass sie mindestens einen Grundierungsdruckkopf enthält, mittels welchem das Textil mit der Grundierungsfarbe bedruckt wird.

Eine vorteilhafte Weiterbildung des erfindungsgemäßen Verfahrens kann darin bestehen, dass die Textilbahn mit einer Markierung versehen wird, wobei die Markierung für einen zuvor eindeutig definierten Auftrag zum Erstellen eines Bekleidungsstücks steht. Hierbei kann der Auftrag wie zuvor beschrieben alle Informationen aufweisen, die für das Herstellen des Bekleidungsstücks notwendig sind. Besonders bevorzugt kann die Markierung eine Zugehörigkeit eines Teilstücks zu einem spezifischen Bekleidungsstück aus einem Auftrag, welcher mehrere Bekleidungsstücke umfasst, angeben.

Weiterhin ist es nach einer Weiterbildung der Erfindung bevorzugt, dass die programmierbare Steuereinheit mittels einer Sensoreinrichtung die mindestens eine Markierung auf der Textilbahn erkennt, ihre Position auf der Textilbahn bestimmt und diese Informationen an die Zuschneideeinrichtung übermittelt, und die Zuschneideeinrichtung, basierend auf den übermittelten Informationen, Teilstücke des zuvor eindeutig definierten Auftrags aus der Textilbahn ausschneidet. Die Sensoreinrichtung kann als integraler Bestandteil der Zuschneideeinrichtung ausgebildet sein. Die programmierbare Steuereinheit kann mit der Sensoreinrichtung in Verbindung stehen und die Sensordaten empfangen und auswerten. Handelt es sich bei der Markierung um ein optisches Zeichen, kann die Sensoreinrichtung beispielsweise als Kamera ausgestaltet sein. Bei andersgearteten, beispielsweise elektronischen oder magnetischen Markierungen kann die Sensoreinrichtung entsprechend ergänzt und/oder angepasst werden, um ein Auslesen der Markierung zu ermöglichen. Wird die Markierung erst nach dem Zuschnitt des auf dem erstellten Teilstück vorgesehen, kann die programmierbare Steuereinheit die Druck-, Zuschneide- und Markiereinrichtung auch direkt und aufeinander abgestimmt steuern, so dass die Markierung zum Zeitpunkt des Zuschnitts noch nicht vorgesehen werden muss, um einen zum Druckbereich und Auftrag passenden Zuschnitt zu gewährleisten. Das Zuschneiden kann mittels eines Lasers durchgeführt werden. Es kann auch eine Oberflächenbehandlung des Textils mit dem Laser erfolgen, etwa eine Aufrauhung, Lochung oder das Bilden besonderer Farbeffekte.

Besonders bevorzugt ist es nach einer Weiterbildung der Erfindung, dass der mindestens eine Textilbereich des Teilstücks, welcher die mindestens eine Markierung aufweist, nach der Fertigung des Bekleidungsstücks abgetrennt wird. Hierzu kann der Textilbereich, welcher die Markierung umfasst, so ausgestaltet sein, dass er sich in besonders einfacher Weise von dem fertigen Bekleidungsstück abtrennen lässt. Die Erfindung wird nachfolgend anhand der beigefügten, schematischen Zeichnung weiter erläutert. In der Zeichnung zeigt:

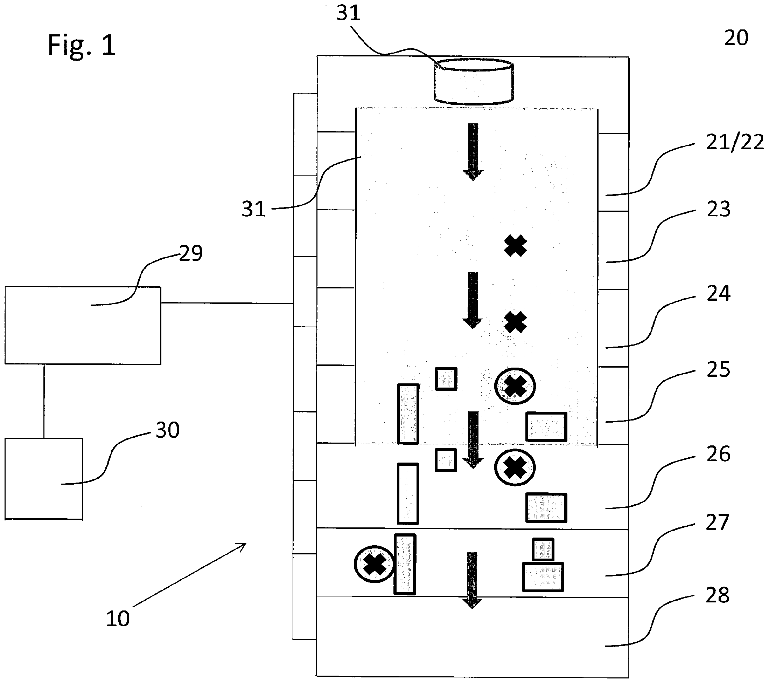

- Fig. 1:: eine schematische Darstellung der erfindungsgemäßen Vorrichtung zum Herstellen eines Bekleidungsstückes.

In Fig. 1 ist eine Vorrichtung 10 zum Herstellen eines Bekleidungsstückes, welches aus mehreren Teilstücken gebildet ist, dargestellt. Die Vorrichtung 10 umfasst eine programmierbare Steuereinrichtung 29, welche die Arbeitsweise der einzelnen Einrichtungen der Vorrichtung zum Herstellen eines Bekleidungsstücks, welches aus mehreren Teilstücken gebildet ist, steuert. So kann ein abgestimmtes Zusammenspiel der Einrichtungen ermöglicht werden. Durch ein Eingabegerät 30, welches wahlweise direkt mit der programmierbaren Steuereinheit 29 verbunden ist oder über ein Fernkommunikationsmittel, beispielsweise das Internet über einen Computer mit geeigneter Software ansteuerbar ist, ist die programmierbare Steuereinrichtung 29 mit einem Auftrag zum Herstellen eines Bekleidungsstücks durch einen Benutzer programmierbar.

Die Vorrichtung 10 umfasst in einem ersten Bereich eine Textilversorgungseinrichtung 20, welche insbesondere eine Textilrolle oder eine andere kontinuierlich ausgebildete Textilquelle als Texteilbahn 31 zur Verfügung stellt. In einem kontinuierlichen Prozess wird die Textilbahn 31 durch die einzelnen Einrichtungen der Vorrichtung zum Herstellen eines Bekleidungsstücks hindurchgeführt.

Mit Hilfe einer Zuführeinrichtung 21 wird die Textilbahn 31 in einem ersten Schritt der Druckeinrichtung 23 zugeführt, mittels welcher die Textilbahn bedruckbar ist. Die Druckeinrichtung 23 umfasst eine Markiereinrichtung 22, mittels welcher in einem vorgegebenen Druckbereich eine Markierung für ein Teilstück eines Bekleidungsstücks auf der Textilbahn 31 auftragbar ist. In Abhängigkeit von dem zu fertigenden Bekleidungsstück wird zuerst eine Grundierungsfarbe durch mindestens eine Grundierungseinrichtung der Druckeinrichtung 23 auf der Textilbahn 31 aufgebracht. Anschließend werden die Markierung und das Druckbild für ein Teilstück eines Bekleidungsstücks in einem Druckbereich auf die Textilbahn 31 vorgesehen.

In einem weiteren Bereich der Vorrichtung wird nach dem Bedrucken der Textilbahn 31 durch eine Sensoreinrichtung 24 die auf der Textilbahn 31 aufgebrachte Markierung und/oder das Druckbild des Teilstücks des Kleidungsstücks erfasst und mittels der mit der Sensoreinrichtung 24 verbundene programmierbaren Steuereinheit 29 verarbeitet. Hierbei kann die programmierbare Steuereinheit 29 auf die Auftragsdaten, welche durch den Benutzer hinterlegt wurde abfragen und so einem Aufdruck und/oder Markierung auf der Textilbahn einem anzuwendenden Schnittmuster zuordnen.

Die erlangte Information zur Ausrichtung und Lage des auszuschneidenden Teilstücks des Bekleidungsstücks sowie das entsprechende Schnittmuster werden durch die programmierbare Steuereinrichtung 29 an die Zuschneideeinrichtung 25 übermittelt. Die Zuschneideeinrichtung 25 schneidet nach den Vorgaben der programmierbaren Steuereinheit 29 das zu erstellende Teilstück des Bekleidungsstücks aus der Textilbahn 31 aus. Die Steuereinheit 29 ermöglicht eine angepasste relative Ausrichtung der einzelnen auszuschneidenden Teilstücke auch verschiedener Bekleidungsstücke auf der Textilbahn 31, so dass durch die programmierbare Steuereinheit 29 ein weitgehend verschnittarmer oder verschnittfreier Zuschnitt der Teilstücke aus der Textilbahn 31 erfolgt.

Bei der Zuschneideeinrichtung 25 kann es sich um eine konventionelle Schneideeinrichtung mit Schneidemessern handeln. Es ist jedoch auch denkbar, den Zuschnitt des Teilstücks aus der Textilbahn durch für den Fachmann geläufige physikalische oder thermische Trennprozesse zu verwirklichen. Beispielsweise kann die Zuschneideeinrichtung auch mit mindestens einem Laser ausgebildet sein, welcher die Textilbahnen an den vorgesehenen Stellen durchtrennt.

Das jeweilige zugeschnittene Teilstück wird anschließend einer Erkennungseinrichtung 26 zugeführt, welche die Zugehörigkeit des Teilstücks zu einem Bekleidungsstück erkennt. Anschließend fasst eine Sortiereinrichtung 27 erkannte Teilstücke des Bekleidungsstücks zusammen. Die programmierbare Steuereinheit 29 steht mit der Erkennungseinrichtung 26 und der Sortiereinrichtung 27 in Verbindung. Durch die programmierbare Steuereinheit 29 erhält die Sortiereinrichtung 27 die notwendigen Anweisungen zum Zusammenfassen der einzelnen Teilstücke eines Bekleidungsstücks. Dies kann etwa über Schieber oder Druckluftdüsen erfolgen. Die programmierbare Steuereinheit 29 kann mittels der Erkennungseinrichtung 26 die Zugehörigkeit einzelner Teilstücke zu einem Bekleidungsstück einerseits anhand des Schnittmusters, des Aufdrucks sowie anhand der Markierung eines Teilstücks erkennen.

Hierbei kann die programmierbare Steuereinheit 29 durch die Sortiereinrichtung 27 auch Teilstücke mehrerer identischer Bekleidungsstücke zu Einheiten, die jeweils nur Teile für ein Bekleidungsstück halten, zusammenfassen.

Die zusammengefassten Teilstücke eines Bekleidungsstücks werden weiter auf einem Transportband den Nähstationen 28 zugeführt. Die Nähstationen 28 verbinden die zusammengefassten Teilstücke zu dem fertigen Bekleidungsstück. Die Zuführung der zusammengefassten Teilstücke des Bekleidungsstücks an die Nähstationen 28 kann wahlweise manuell oder durch eine Fördereinrichtung geschehen. So kann eine Vielzahl von Nähstationen 28 vorgesehen und mit zusammengefassten Teilstücken eines Bekleidungsstücks versorgt werden.

## Patentansprüche

1. Vorrichtung zum Herstellen eines Bekleidungsstücks, welches aus mehreren Teilstücken gebildet ist, mit
- einer Textilversorgungseinrichtung (20), mit mindestens einer Textilbahn (31),
- einer Druckeinrichtung (23), mittels welcher die mindestens eine Textilbahn (31) bedruckbar ist,
- einer Zuführeinrichtung (21), durch welche die mindestens eine Textilbahn (31) der Druckeinrichtung (23) zuführbar ist,
- einer programmierbaren Steuereinheit (29), mittels welcher die Druckeinrichtung (23) zum Bedrucken der Textilbahn (31) steuerbar ist, wobei mindestens ein Teilstück bedruckt wird,
- einer Zuschneideeinrichtung (25), mittels welcher die mindestens eine Textilbahn (31) zu den Teilstücken zuschneidbar ist, und
- mindestens einer Nähstation (28), durch welche die Teilstücke zu dem Bekleidungsstück verbindbar sind,
und
- wobei zwischen der Zuschneideeinrichtung (25) und der mindestens einen Nähstation (28) eine Erkennungseinrichtung (26) angeordnet ist, welche die Teilstücke eines Bekleidungsstücks erkennt, und
- wobei eine Sortiervorrichtung (27) vorgesehen ist, welche mit der Erkennungseinrichtung (26) in Verbindung steht und die Teilstücke eines Bekleidungsstücks zusammenfasst und der mindestens einen Nähstation (28) zuführt, die Vorrichtung ist **dadurch gekennzeichnet, dass** die Druckeinrichtung dahingehend ausgestaltet ist, dass sie mindestens einen Grundierungsdruckkopf enthält, mittels welchem das Textil flächig mit einer Grundierungsfarbe bedruckbar ist.

2. Vorrichtung nach Anspruch 1,
**dadurch gekennzeichnet,**
**dass** die Druckeinrichtung (23) mindestens einen digitalen Druckkopf umfasst, wobei die mindestens eine Textilbahn (31) durch den mindestens einen digitalen Druckkopf mit digitaler Druckerfarbe bedruckbar ist.

3. Vorrichtung nach Anspruch 1 oder 2,
**dadurch gekennzeichnet,**
- **dass** eine Markierungseinrichtung (22) vorgesehen ist, durch welche jedes Teilstück eines Bekleidungsstückes mit einer Markierung versehbar ist, und
- **dass** die Markierung ausgebildet ist, eine Zugehörigkeit der Teilstücke zu einem Bekleidungsstück anzugeben.

4. Vorrichtung nach Anspruch 3,
**dadurch gekennzeichnet,**
**dass** die Markierung bereits vor dem Zuschnitt der Teilstücke auf der Textilbahn (31) vorsehbar ist.

5. Vorrichtung nach einem der Ansprüche 3 oder 4,
**dadurch gekennzeichnet,**
**dass** die Teilstücke mindestens einen Textilbereich aufweisen, welcher die Markierung umfasst, wobei der Textilbereich außerhalb des Schnittmusters des Bekleidungsstücks liegt.

6. Vorrichtung nach einem der Ansprüche 1 bis 5,
**dadurch gekennzeichnet,**
**dass** die programmierbare Steuereinheit (29) ausgebildet ist, von einem Kunden gesendete Bild- und Auftragsdaten zu empfangen und auf der Textilbahn (31) in einem vorgesehenen Druckbereich ein entsprechendes Druckbild für einen Teilstück eines Bekleidungsstückes mittels der Druckeinrichtung (23) aufzubringen.

7. Vorrichtung nach einem der Ansprüche 1 bis 6,
**dadurch gekennzeichnet,**
**dass** die Textilbahn (31) mit einer Grundfarbe vorgesehen ist und
**dass** die Druckeinrichtung (23) ausgebildet ist, flächig eine neue Grundfarbe aufzubringen.

8. Verfahren zum Herstellen eines Bekleidungsstücks, welches aus mehreren Teilstücken gebildet ist, mit einer Vorrichtung zum Herstellen eines Bekleidungsstücks nach einem der Ansprüche 1 bis 7, bei welchem
- eine Zuführeirichtung (21) einer Druckeinrichtung (23) mindestens eine Textilbahn (31) aus einer Textilversorgungseinrichtung (20) zuführt,
- die Druckeinrichtung mit mindestens einem Grundierungsdruckkopf das Textil flächig mit einer Grundierungsfarbe bedruckt,
- die Druckeinrichtung (23) die mindestens eine Textilbahn (31) bedruckt,
- eine programmierbare Steuereinheit (29) die Druckeinrichtungen (23) zum Bedrucken der Textilbahn (31) steuert,
- eine Zuschneideeinrichtung (25) die bedruckte Textilbahn (31) zu Teilstücken zuschneidet, und
- in mindestens einer Nähstation (28) die Teilstücke zu einem Bekleidungsstück verbunden werden,
und
- eine Erkennungseinrichtung (26) die Teilstücke eines Bekleidungsstückes erkennt und
- eine Sortiervorrichtung (27), welche mit der Erkennungseinrichtung (26) in Verbindung steht, die erkannten Teilstücke eines Bekleidungsstücks zusammenfasst und der mindestens einen Nähstation (28) zuführt.

9. Verfahren nach der Anspruch 8,
**dadurch gekennzeichnet,**
**dass** die Textilbahn (31) mit einer Markierung versehen wird, wobei die Markierung für einen zuvor eindeutig definierten Auftrag zur Erstellung eines Bekleidungsstücks steht.

10. Verfahren nach Anspruch 9,
**dadurch gekennzeichnet,**
- **dass** die programmierbare Steuereinheit (29) mittels einer Sensoreinrichtung (24) die mindestens eine Markierung auf der Textilbahn erkennt, ihre Position auf der Textilbahn (31) bestimmt und diese Informationen an die Zuschneideeinrichtung (25) übermittelt,
- **dass** die Zuschneideeinrichtung (25) basierend auf den übermittelten Informationen Teilstücke des zuvor eindeutig definierten Auftrags zur Erstellung eines Bekleidungsstücks aus der Textilbahn (31) ausschneidet.

11. Verfahren nach einem der Ansprüche 9 oder 10,
**dadurch gekennzeichnet,**
**dass** der mindestens eine Textilbereich des Teilstücks, welcher die mindestens eine Markierung aufweist, nach der Fertigung des Bekleidungsstück abgetrennt wird.

## Claims

1. Device for producing a garment which is formed from a plurality of part pieces, having
- a textile supply means (20), having at least one textile web (31),
- a printing means (23), by means of which the at least one textile web (31) can be printed,
- a feed means (21), through which the at least one textile web (31) can be fed to the printing means (23),
- a programmable control unit (29), by means of which the printing means (23) can be controlled to print the textile web (31), wherein at least one part piece is printed,
- a cutting means (25), by means of which the at least one textile web (31) can be cut to form the part pieces, and
- at least one sewing station (28), through which the part pieces can be joined to form the garment, and
- a detection means (26) is arranged between the cutting means (25) and the at least one sewing station (28), which detection means (26) detects the part pieces of a garment, and
- a sorting device (27) is provided which is connected to the detection means (26) and brings the detected part pieces of a garment together and feeds them to the at least one sewing station (28),
the device is **characterised in that**
the printing means is adapted so that it has at least one priming head by means of which the textile can be two-dimensionally printed with a primer.

2. Device according to claim 1,
**characterised in that**
the printing means (23) comprises at least one digital printing head, wherein the at least one textile web (31) can be printed by the at least one digital printing head with digital printing ink.

3. Device according to claim 1 or 2,
**characterised in that**
- a marking means (22) is provided, through which each part piece of a garment can be provided with a marking, and
- the marking is designed to indicate a belonging of the part pieces to a garment.

4. Device according to claim 3,
**characterised in that**
the marking can be provided on the textile web (31) already before the cutting of the part pieces.

5. Device according to one of claims 3 or 4,
**characterised in that**
the part pieces have at least one textile area which comprises the marking, wherein the textile area lies outside of the cutting pattern of the garment.

6. Device according to one of claims 1 to 5,
**characterised in that**
the programmable control unit (29) is designed to receive image and order data sent by a client and to apply a corresponding print image, on the textile web (31) in a provided print area, for a part piece of a garment by means of the printing means (23).

7. Device according to one of claims 1 to 6,
**characterised in that**
the textile web (31) is provided with a base colour and
that the printing means (23) is designed to apply two-dimensionally a new base colour.

8. Method for producing a garment which is formed from a plurality of part pieces with a device for producing a garment according to one of claims 1 to 7, wherein
- a feed means (21) feeds at least one textile web (31) from a textile supply means (20) to a printing means (23),
- the printing means prints with at least one priming head the textile two-dimensionally with a primer.
- the printing means (23) prints the at least one textile web (31),
- a programmable control unit (29) controls the printing means (23) to print the textile web (31),
- a cutting means (25) cuts the printed textile web (31) to part pieces, and
- the part pieces are joined to form a garment in at least one sewing station (28), and
- a detection means (26) detects the part pieces of a garment and
- a sorting device (27) which is connected to the detection means (26) brings the detected part pieces of a garment together and feeds them to the at least one sewing station (28).

9. Method according to claim 8,
**characterised in that**
the textile web (31) is provided with a marking, wherein the marking stands for a previously clearly defined order to create a garment.

10. Method according to claim 9,
**characterised in that**
- the programmable control unit (29) detects, by means of a sensor means (24), the at least one marking on the textile web, determines its position on the textile web (31) and transmits this information to the cutting means (25),
- that the cutting means (25), based on the transmitted information, cuts from the textile web (31) part pieces of the previously clearly defined order to create a garment.

11. Method according to one of claims 9 or 10,
**characterised in that**
the at least one textile area of the part piece which has the at least one marking is separated after the production of the garment.

## Revendications

1. Dispositif servant à fabriquer un article d'habillement, lequel est formé à partir de plusieurs pièces partielles, avec
- un système d'alimentation en textile (20) avec au moins une bande de textile (31),
- un système d'impression (23), au moyen duquel l'au moins une bande de textile (31) peut être imprimée,
- un système d'amenée (21), par lequel l'au moins une bande de textile (31) peut être amenée au système d'impression (23),
- une unité de commande (29) programmable, au moyen de laquelle le système d'impression (23) servant à imprimer la bande de textile (31) peut être commandé, dans lequel au moins une pièce partielle est imprimée,
- un système de découpe (25), au moyen duquel l'au moins une bande de textile (31) peut être découpée en les pièces partielles, et
- au moins un poste de couture (28), par lequel les pièces partielles peuvent être assemblées en l'article d'habillement,
et
- un système d'identification (26), lequel identifie les pièces partielles d'un article d'habillement, est disposé entre le système de découpe (25) et l'au moins un poste de couture (28), et
- un dispositif de tri (27), lequel est relié au système d'identification (26) et regroupe les pièces partielles d'un article d'habillement et les amène à l'au moins un poste de couture (28), le dispositif est **caractérisé en ce que**
le système d'impression est configuré de manière à contenir au moins une tête d'impression de couche de fond, au moyen de laquelle le textile peut être imprimé sur la surface avec une encre de couche de fond.

2. Dispositif selon la revendication 1,
**caractérisé en ce**
**que** le système d'impression (23) comprend au moins une tête d'impression numérique, dans lequel l'au moins une bande de textile (31) peut être imprimée d'une encre d'impression numérique par l'au moins une tête d'impression numérique.

3. Dispositif selon la revendication 1 ou 2,
**caractérisé en ce**
- **qu'**est prévu un système de marquage (22), par lequel chaque pièce partielle d'un article d'habillement peut être pourvue d'un marquage, et
- **que** le marquage est réalisé pour indiquer une appartenance des pièces partielles à un article d'habillement.

4. Dispositif selon la revendication 3,
**caractérisé en ce**
**que** le marquage peut être prévu déjà avant la découpe des pièces partielles sur la bande de textile (31).

5. Dispositif selon l'une quelconque des revendications 3 ou 4,
**caractérisé en ce**
**que** les pièces partielles présentent au moins une zone de textile, laquelle comprend le marquage, dans lequel la zone de textile se situe à l'extérieur du modèle de coupe de l'article d'habillement.

6. Dispositif selon l'une quelconque des revendications 1 à 5,
**caractérisé en ce**
**que** l'unité de commande (29) programmable est réalisée pour recevoir des données d'image et de commande envoyées par un client et pour appliquer sur la bande de textile (31) dans une zone d'impression prévue une image d'impression correspondante pour une pièce partielle d'un article d'habillement au moyen du système d'impression (23).

7. Dispositif selon l'une quelconque des revendications 1 à 6,
**caractérisé en ce**
**que** la bande de textile (31) est prévue avec une couleur de base et
**que** le système d'impression (23) est réalisé pour appliquer sur la surface une nouvelle couleurde base.

8. Procédé servant à fabriquer un article d'habillement, lequel est formé à partir de plusieurs pièces partielles, avec un dispositif servant à fabriquer un article d'habillement selon l'une quelconque des revendications 1 à 7, où
- un système d'amenée (21) amène à un système d'impression (23) au moins une bande de textile (31) provenant d'un système d'alimentation en textile (20),
- le système d'impression imprime avec au moins une tête d'impression de couche de fond le textile sur la surface avec une encre de couche de fond,
- le système d'impression (23) imprime l'au moins une bande de textile (31),
- une unité de commande (29) programmable commande les systèmes d'impression (23) servant à imprimer la bande de textile (31),
- un système de découpe (25) découpe la bande de textile (31) imprimée en pièces partielles, et
- les pièces partielles sont assemblées en un article d'habillement dans l'au moins un poste de couture (28),
et
- un système d'identification (26) identifie les pièces partielles d'un article d'habillement, et
- un dispositif de tri (27), lequel est relié au système d'identification (26), regroupe les pièces partielles identifiées d'un article d'habillement et les amène à l'au moins un poste de couture (28).

9. Procédé selon la revendication 8,
**caractérisé en ce**
**que** la bande de textile (31) est pourvue d'un marquage, dans lequel le marquage représente une commande de création d'un article d'habillement clairement définie au préalable.

10. Procédé selon la revendication 9,
**caractérisé en ce**
- **que** l'unité de commande (29) programmable identifie au moyen d'un système de capteur (24) l'au moins un marquage sur la bande de textile, détermine sa position sur la bande de textile (31) et transmet cette information au système de découpe (25),
- **que** le système de découpe (25) sépare par découpage de la bande de textile (31), sur la base des informations transmises, des pièces partielles de la commande de création d'un article d'habillement clairement définie au préalable .

11. Procédé selon l'une quelconque des revendications 9 ou 10,
**caractérisé en ce**
**que** l'au moins une zone textile de la pièce partielle, laquelle présente l'au moins un marquage, est détachée après la production de l'article d'habillement.
